# EUROPEAN PATENT APPLICATION

(11) **EP 4 788 075 A1**
(43) Date of publication of application: **05.08.2026**
(21) Application number: 26156261.5
(22) Date of filing: 04.02.2026
(51) Int. Cl.: H05K 7/20

(54) **EVAPORATIVE FREECOOLING UNIT FOR LIQUID COOLING SYSTEM**

(30) Priority: 04.02.2025 US 202563753651 P; 02.02.2026 US 202619466847
(71) Applicant: Vertiv International GmbH, 8212 Neuhausen am Rheinfall (CH)
(72) Inventor: LUCCHETTA, Fabio, Neuhausen am Rheinfall 8212 (CH); TRAMARIN, Davide, Neuhausen am Rheinfall 8212 (CH); DE ZEN, Daniele, Neuhausen am Rheinfall 8212 (CH)
(74) Representative: Beal, James Michael

(57) **Abstract**

The present disclosure is directed to a hybrid, indirect evaporative free cooling system that includes liquid cooling. The cooling system includes an air-to-air heat exchanger and a first water coil located beneath the air-to-air heat exchanger. The system further includes a first fan unit configured to draw air through the first water coil and the air-to-air heat exchanger in a first direction, wherein the first fan unit is further configured to exhaust air to a location external to the data center and a second fan unit configured to blow air from the data center, in a second direction perpendicular to the first direction, through the air-to-air heat exchanger. A coolant distribution unit is configured to provide cooling fluid to the first water coil.

## Description

### TECHNICAL FIELD

Apparatuses and methods for cooling large thermal loads, such as those of a data center, are disclosed.

### BACKGROUND

Modern data centers, through the use of a large number of computing systems, generate a significant amount of heat. Accordingly, cooling systems such as evaporative freecooling (EFC) units are utilized to remove excess heat from computing systems within a data center. In an EFC unit, water may be sprayed or otherwise flow over a medium such as pads, plate air-to-air heat exchanger or coils. Specifically, the EFC is an indirect evaporative cooling unit, meaning that the fluid that needs to be cooled (e.g. warm air from the data center) never gets in contact with the water, that flows on the opposite side of the medium (e.g. heat exchanger plates). When warm air (e.g., from the data center) passes across the dry side of the plates, the water flowing on the other side of the plates evaporates, absorbing heat and cooling the warm air, thereby providing the evaporative cooling function. The free-cooling function may be provided when the outside ambient air is cooler than that of the indoor environment and is passed over plates that form channels in an air-to-air heat exchanger.

### SUMMARY

The present disclosure is directed to a hybrid EFC cooling system that includes liquid cooling. In one embodiment, a cooling system includes an air-to-air heat exchanger and a first water coil located beneath the air-to-air heat exchanger. The system further includes a first fan unit configured to draw air through the first water coil and the air-to-air heat exchanger in a first direction, wherein the first fan unit is further configured to exhaust air to a location external to the data center and a second fan unit configured to blow air from the data center, in a second direction normal to the first direction, through the air-to-air heat exchanger. A coolant distribution unit is configured to provide cooling fluid to the first water coil.

### BRIEF DESCRIPTION OF THE DRAWINGS

The above and/or other aspects will become apparent and more readily appreciated from the following description of example embodiments, taken in conjunction with the accompanying drawings, in which:
FIG. 1 is a schematic diagram of a cooling system.
FIG. 2 is a schematic diagram of a cooling system operating in a first mode.
FIG. 3 is a schematic diagram of a cooling system operating in a second mode.
FIG. 4 is a schematic diagram of a cooling system operating in a third mode.
FIG. 5 is a schematic diagram of a cooling system operating in a fourth mode.
FIG. 6 is a block diagram of a cooling system and a data center.
FIG. 7 is a block diagram of another cooling system and a data center.
FIG. 8 is a block diagram of another cooling system and a data center.

### DETAILED DESCRIPTION

Reference will now be made in detail to example embodiments which are illustrated in the accompanying drawings, wherein like reference numerals refer to like elements throughout. In this regard, the example embodiments may have different forms and may not be construed as being limited to the descriptions set forth herein.

It will be understood that the terms "include," "including," "comprise," and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names - this document does not intend to distinguish between components that differ in name but not function.

Matters of these example embodiments that are obvious to those of ordinary skill in the technical field to which these example embodiments pertain may not be described herein in detail.

It may be understood that the example embodiments described herein may be considered in a descriptive sense only and not for purposes of limitation. Descriptions of features or aspects within each example embodiment may be considered as available for other similar features or aspects in other example embodiments.

Evaporative free cooling (EFC) are cooling systems that leverage the principles of evaporative cooling and free cooling to reduce energy consumption in climate control applications, often in data centers, industrial facilities, or large commercial buildings. An EFC is typically an outdoor unit that provides air cooling for the facility, utilizing a large, air-to-air heat exchanger along with evaporative free cooling technology.

In recent years, facilities such as data centers are transitioning from an air-based low-density cooling to a liquid-based high-density cooling of the servers. The present disclosure makes use of the insight that, during a transition phase, facilities may utilize systems having the flexibility to handle both air cooling and liquid cooling. Furthermore, even upon completion of the transition, some systems will utilize a combination of liquid cooling and air cooling.

In light of the above, the present disclosure is directed to a cooling system for a facility, such as a data center (but not limited thereto) that utilizes a combination of air cooling and liquid cooling and is capable of operating in a number of different modes that utilize various combinations of air and liquid cooling. The cooling system of the present disclosure takes advantage of the evaporative/adiabatic section of the unit, allowing full free cooling of the air or the liquid without increasing the footprint of the original unit. This is obtained by placing a stainless steel or coated water free cooling coil below the air-to-air heat exchanger. The unit of the present disclosure may operate at 100% air cooling, 100% liquid cooling, or various combinations in between. Embodiments of a cooling system according to the disclosure are now discussed in further detail.

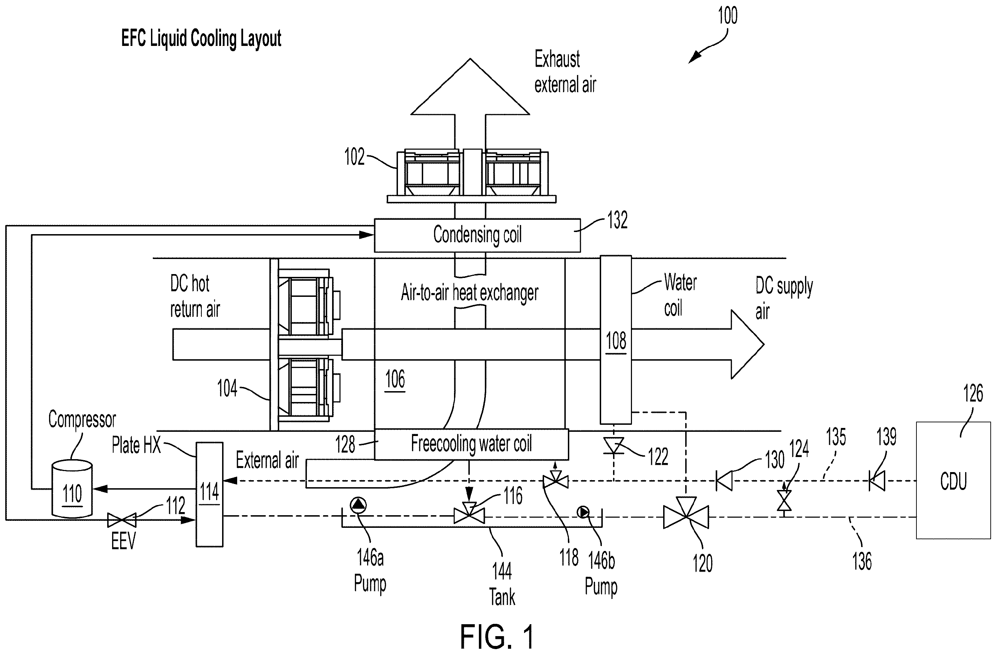

FIG. 1 is a schematic diagram of a cooling system. In the embodiment shown, cooling system 100 includes a first fan unit 102, a second fan unit 104, a free cooling water coil 128, and another water coil 108, all of which are arranged in the vicinity of an air-to-air heat exchanger 106. Free cooling water coil 128, located underneath air-to-air heat exchanger 106, is coupled to a warm water pipe 135 via a three-way valve 118, and a cold water pipe 136 via a three-way valve 116. Warm water may be received by free cooling water coil 128 from coolant distribution unit 126 (which may alternatively be referred to as a cooling distribution unit) via three-way valve 118. Cold water may be provided to coolant distribution unit 126 via three-way valve 116. Cold water may be provided to water coil 108 via three-way valve 120, with warm water provided therefrom to warm water pipe 135 via check valve 122. Cold water and warm water may be recirculated between the pipes via valve 124 (valve 124 may be optional in various embodiments, as it may be contained within coolant distribution unit 126). The system as shown here also includes a heat exchanger 114, which may receive warm water and provide cool water, condensing coil 132, and compressor 110. The respective functions of these various units are now described. Pumps 146a and 146b are also provided to circulate/recirculate water through warm water pipe 135 and cold water pipe 136 and the various equipment coupled thereto (either directly or indirectly). Pump 146a in the embodiment shown is a submersible pump placed within tank 144 that feeds the water sprayers of the evaporative system below the condensing coil 132. Pump 146b in the embodiment shown is arranged to move water that feeds the coolant distribution unit 126 and the water coils. Check valves 130 and 139 are also provided to enable various configurations of cooling system 100.

Coolant distribution unit 126 takes hot fluid from the servers via a pump and cools it down via a heat exchanger that receives cold water from the cooling equipment. Coolant distribution unit 126 then circulates cold fluid back to the servers to cool them down.

The fans of second fan unit 104 extract warm air from the data center (or other facility) and push this air through air-to-air heat exchanger 106 and water coil 108. This cools the air so that it may extract heat from equipment (e.g., servers) within the facility). While this air does not directly mix with the air moved by the fans of first fan unit 102, it is nevertheless continuously cooled and re-injected into the facility to cool the equipment therein. It is noted that the equipment in the facility may be cooled by air, liquid (that passes through the equipment), or a combination of the two.

Air-to-air heat exchanger 106 in various embodiments comprises a number of plates forming channels that allow heat transfer between air from the facility and external ambient air without any mixing of the two. In some embodiments, when the external air is hot, water may be sprayed on the heat exchanger, from the top, thereby wetting plates on the external air side and triggering an indirect, evaporative cooling effect.

Water coil 108 may be used to cool the air flowing into the facility, providing additional cooling in the event that the cooling provided by air-to-air heat exchanger is not sufficient to meet the cooling demand. In various modes of operation, water may be provided to water coil from heat exchanger 114 or from water coil 128.

Water coil 128, which may be referred to as the free cooling water coil, is used to cool the warm water received from the coolant distribution unit 126. More particularly, this unit allows heat transfer between warm water and cool, ambient air pulled in by fans of fan unit 102. In some modes (e.g., warm summer modes), this water coil may be wetted by sprayed water to leverage an indirect, free cooling effect.

Condensing coil 132 in the illustrated example is the condenser of the refrigerant circuit (that also includes heat exchanger 114 and compressor 110). Condensing coil 132 rejects heat absorbed by the refrigerant after compression by compressor 110. The heat rejected by condensing coil is then removed by ambient air pulled by fans of fan unit 102 across water coil 128 and through air-to-air heat exchanger 106. In various embodiments, condensing coil may be placed above any water sprayers such that it is not wetted by sprayed water.

Cooling system 100 in the embodiment shown also includes a plate heat exchanger 114, which 114 may act as an evaporator of the refrigerant circuit and may cool warm water coming (via the various valves) from coolant distribution unit 126. This may be performed by evaporating refrigerant, which absorbs heat from the water. Heat exchanger 114 may include a number of thin plates (which may be corrugated) that are stacked together and transfer heat between two different fluids. Warm water may be provided from coolant distribution unit 126 to plate heat exchanger 114 via three-way valve 118 and pump. Cold water may be provided from plate heat exchanger 114 back to coolant distribution unit 126 via three-way valves 116 and 120 and a pump. As will be discussed in further detail below, plate heat exchanger 114 may perform a heat exchange between the cooling water provided thereto and a refrigerant.

Cooling system 100 is also augmented by the refrigerant circulating loop that includes compressor 110, condensing coil 132, and electronic expansion valve (EEV) 112. The refrigerant circulating loop interfaces with the plate heat exchanger 114, allowing for the exchange of heat between refrigerant and cooling water. Warm water may be provided to plate heat exchange 114, transferring heat to refrigerant received therein via EEV 112. The warmed refrigerant is then provided to compressor 110, which compresses the received refrigerant into a high-pressure, high temperature vapor that is provided to condensing coil 132, where the refrigerant is once again condensed and thus heat is removed from the system. The heat rejected from condensing coil 132 is drawn through fans in fan unit 102 and exhausted to the air external to the facility being cooled.

In various modes of operation, warm air from the facility is blown into air-to-air heat exchanger by fans in fan unit 104. Cool air is drawn upward, through free cooling water coil 128, through air-to-air heat exchanger 106, and condensing coil 132 by fans in fan unit 102. The warm air blown in from the facility by fans of fan unit 104 exchanges heat with the cool air drawn upward through air-to-air heat exchanger 106. Given the arrangement of the fans in fan units 102 and 104, the direction of airflow induced by these two units is normal (perpendicular) to each other. The air flow induced by fans from fan unit 104 exits air-to-air heat exchanger 106 cooler than when it entered. This air is further cooled by water coil 108, which receives cold water three-way valve 120, while warm water resulting from the additional absorption of heat may be provided to warm water pipe 135 via check valve 122.

The various valves, free cooling water coil 128, coolant distribution unit 126, and plate heat exchanger may be implemented external to a facility, such as a data center (in various embodiments, portions of system 100 up to the pipes 135 and 136 are outside the facility while the coolant distribution unit 126 may be inside or in a machinery room). Moreover, the added components may provide liquid cooling to the facility, augmenting air cooling provided using the fan units 102 and 104 and air-to-air heat exchanger 106. Furthermore, using these components, cooling system 100 may operate in various different modes, some of which are discussed below.

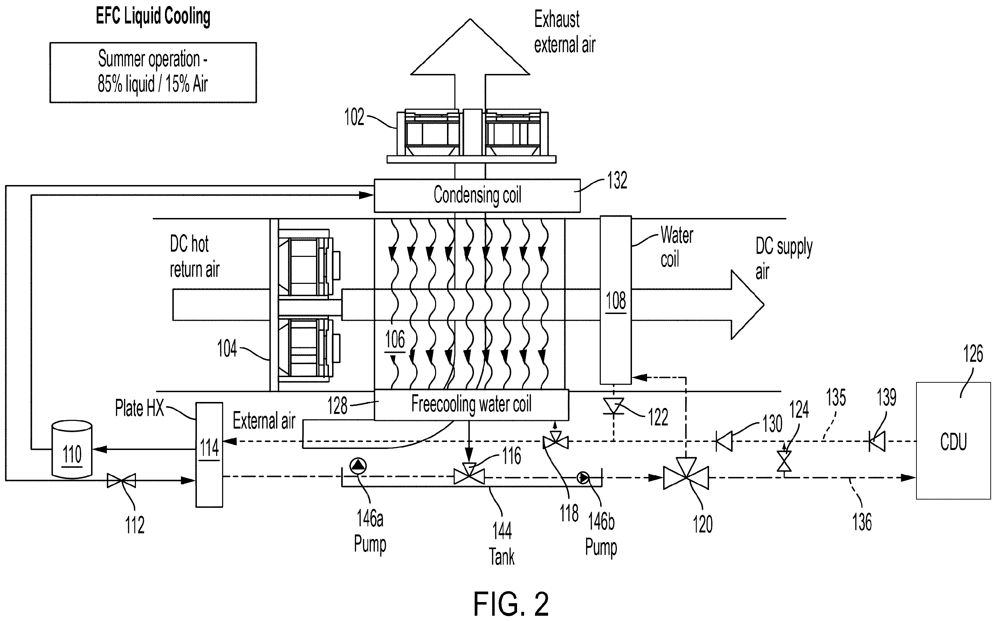

FIG. 2 is a schematic diagram of a cooling system operating in a first mode. The mode of operation depicted in FIG. 2 is referred to here as a summer hybrid mode, as it may be utilized during months when the temperature is higher (typically associated with summer) and provides both liquid and air cooling.

In this mode, the liquid cooling may include circulating warm water from coolant distribution unit 126 to free cooling water coil 128 and to plate heat exchanger 114. A check valve 130 is present in this example to prevent back flow of warm water into coolant distribution unit 126. Cold water is provided from plate heat exchanger 114 and free cooling water coil 128, via three-way valves 116 and 120, to coolant distribution unit 126. Additionally, cold water is also circulated to water coil 108 via three-way valve 128 and back to warm water pipe 135 via check valve 122.

During operation in this mode of operation, the refrigerant system is also operational. Accordingly, heat is exchanged between cooling water and refrigerant in plate heat exchanger 114. Compressor 110 compresses the refrigerant, which is then provided to condensing coil 132. A water source comprising sprayers (not shown) may be provided to spray water onto air-to-air heat exchanger 106 and water coil 128. The spraying of water onto these units may facilitate air and liquid cooling through indirect evaporative cooling on the air-to-air heater exchanger 106, indirect evaporative cooling on water coil 128, and adiabatic cooling of external air drawn into the system by fans of fan unit 102. Thus, the sprayed water may adiabatically cool down the external ambient air entering the system from the outside. Additionally since this water may evaporate on plates that are in contact with the warm air to be cooled, further heat is extracted from the warm air as an indirect evaporative cooling effect for both the air and the warm water. The water sprayed may be collected in a water tank 144 and recirculated back to the sprayers using pump 146a. The sprayers may be located beneath condensing coil 132 and above air-to-air heat exchanger 106.

The air cooling in the summer hybrid mode may be carried out as discussed above, drawing cool air upward through air-to-air heat exchanger 106 using fans of fan unit 102. The air drawn by fans of fan unit 102 may be cooled by water sprayed from sprayers located between condensing coil 132 and air-to-air heat exchanger 106. This may in turn provide cooling to warm water entering water coil 128, to the air drawn by fans of fan unit 104, or both.

Warm air from the facility (e.g., a data center) may be blown into air-to-air heat exchanger 106, by fans of fan unit 104, in a direction perpendicular to that in which cool air is drawn upward by fans of fan unit 102. As noted above, the air drawn by fans of fan unit 102 does not directly mix with air drawn by the fans of fan unit 104, due to plates in air-to-air heat exchanger that forms channels for airflow in directions perpendicular to one another. Additional heat may be removed from the air forced through air-to-air heat exchanger 106 by fans of fan unit 104 as it passes over water coil 108. This may result in cool air being exhausted into the facility to provide cooling for equipment therein, such as a number of servers. Meanwhile, warm air may be exhausted into the ambient air external to the facility by the fans of fan unit 102.

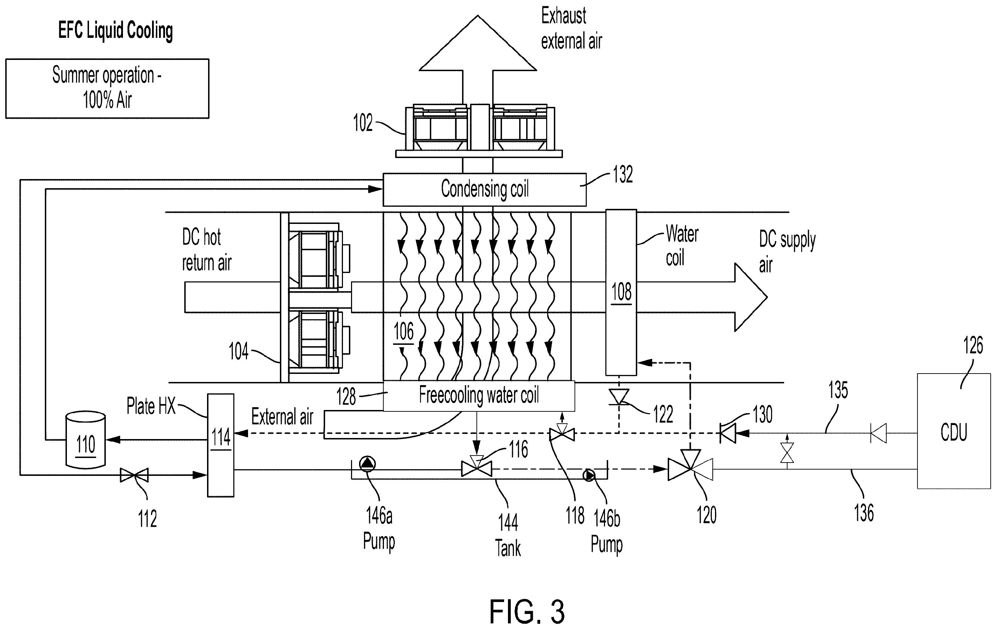

FIG. 3 is a schematic diagram of a cooling system operating in a second mode, referred to here as the summer air cooling mode. In this mode of operation, the warm water from coolant distribution unit 126 is not used and thus is not circulated. Accordingly, the water loop is used only to cool the air blown by fans of fan unit 104 through water coil 108. Instead, three-way valves 120 is arranged to inhibit cold water from being provided to coolant distribution unit 126 while check valve 130 prevents back flow of warm water. Furthermore, three-way valve 118 is arranged in this mode to inhibit cooling water from being provided to free cooling water coil 128. Accordingly, cooling water in this mode is circulated by a pump 146b between water coil 108 and plate heat exchanger 114.

Refrigerant circulation in this mode of operation occurs as normal, with compressor 110 performing compression of refrigerant into high temperature, high pressure vapor that is provided to condensing coil 132, where the refrigerant is subsequently condensed and passed back to plate heat exchanger 114 via expansion valve 112.

Air cooling in this embodiment occurs in this mode occurs in the same manner as the summer hybrid mode, with air drawn upward through air-to-air heat exchanger 106 by fans of fan unit 102 exchanging heat with air blown into the heat exchanger, in a perpendicular direction, by fans of fan unit 104.

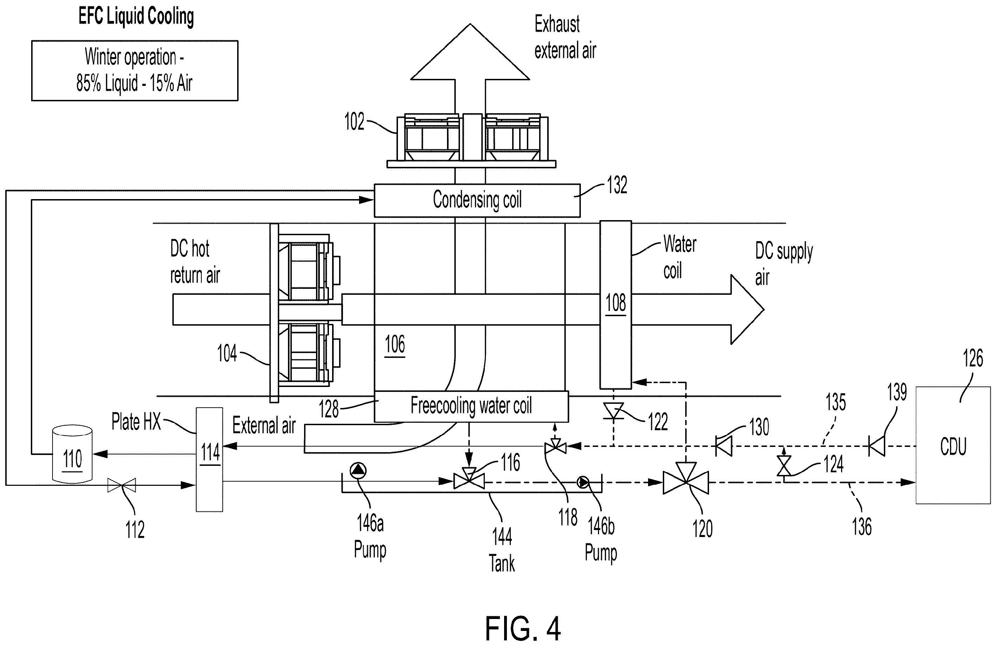

FIG. 4 is a schematic diagram of a cooling system operating in a third mode. This mode is referred to herein as a winter hybrid cooling mode, and provides both active liquid cooling along with air cooling. In this mode of operation, the various valves of the system are positioned such that cooling water is actively circulated between coolant distribution unit 126, free cooling water coil 128, and water coil 108. However, the refrigerant system in this mode may be idle, with compressor 110 not operating while no cooling water is circulated through plate heat exchanger 114.

Air cooling may be carried out in a manner similar to that of the modes discussed above when operating in the winter hybrid cooling mode. However, in this mode, the refrigerant portion of the system is idle.

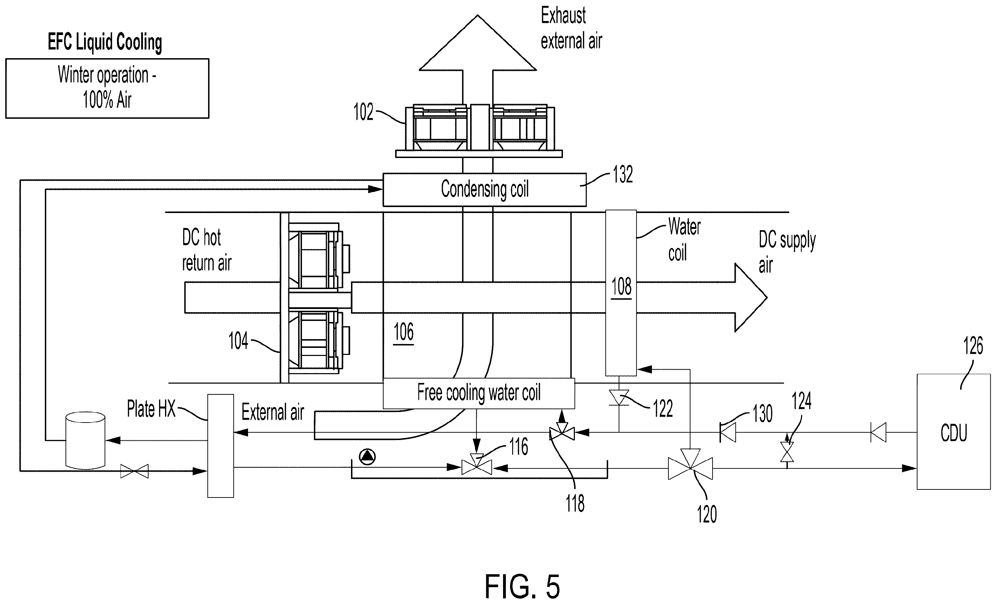

FIG. 5 is a schematic diagram of a cooling system operating in a fourth mode. This mode is referred to herein as the winter air cooling mode. In this mode, there is no circulation of either cooling water or refrigerant. Instead, all cooling is carried out in air-to-air heat exchanger 106 by heat exchange between cold air from external to the facility with warm air from within the facility. The warm air is exhausted from the facility by fans of fan unit 102, while cool air is blown back into the facility. This mode of operation may be particularly suitable for weather in which the outdoor temperature is significantly lower than the indoor temperature, such as during the winter months in certain locations.

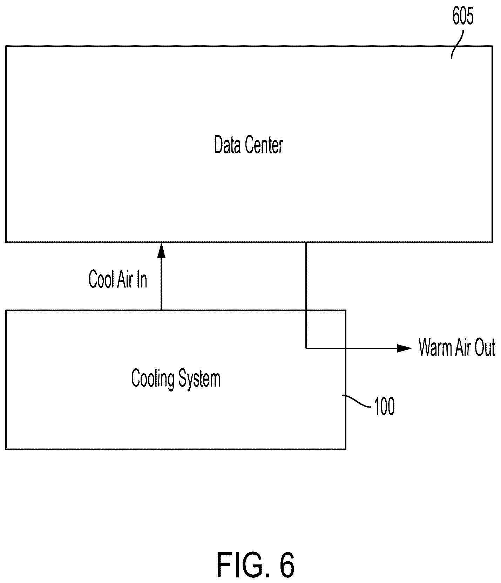

FIGS. 6-8 are block diagrams of various implementations of a cooling system and a facility, such as a data center. Data center 605 is one example of a facility with which the cooling system 100 of the present disclosure may be utilized. Other examples of a facility in which cooling system 100 may be utilized include various factories and industrial facilities. More generally, any facility in which it is desirable to extract heat therefrom to ensure proper operation and prevent overheating of equipment may utilize an embodiment of cooling system 100 in accordance with this disclosure.

In the illustrated example, cooling system 100 may correspond to various embodiments of the cooling system discussed above. Utilizing fans and various liquid cooling systems that circulate cold water and/or refrigerant in accordance with the various embodiments discussed above, warm air is pulled from the facility by the cooling equipment and cooled down before being re-injected into the facility.

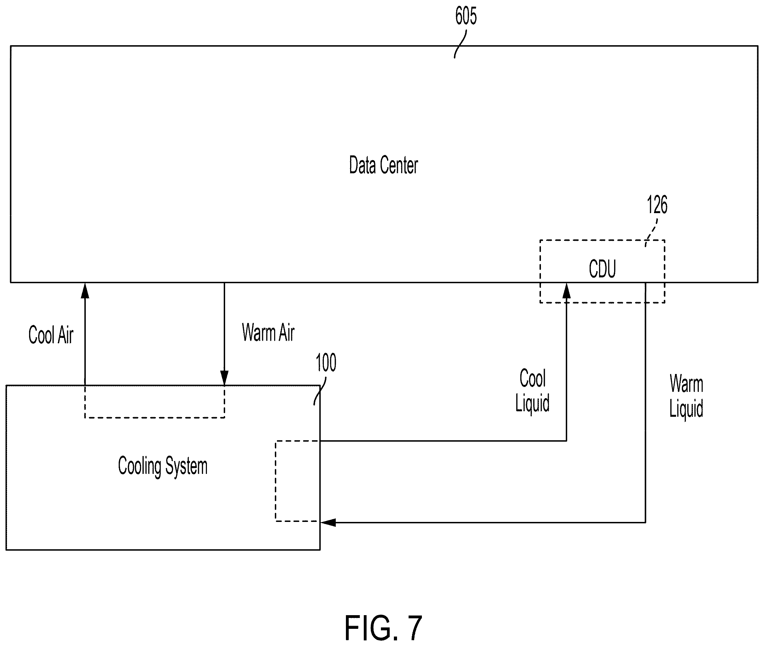

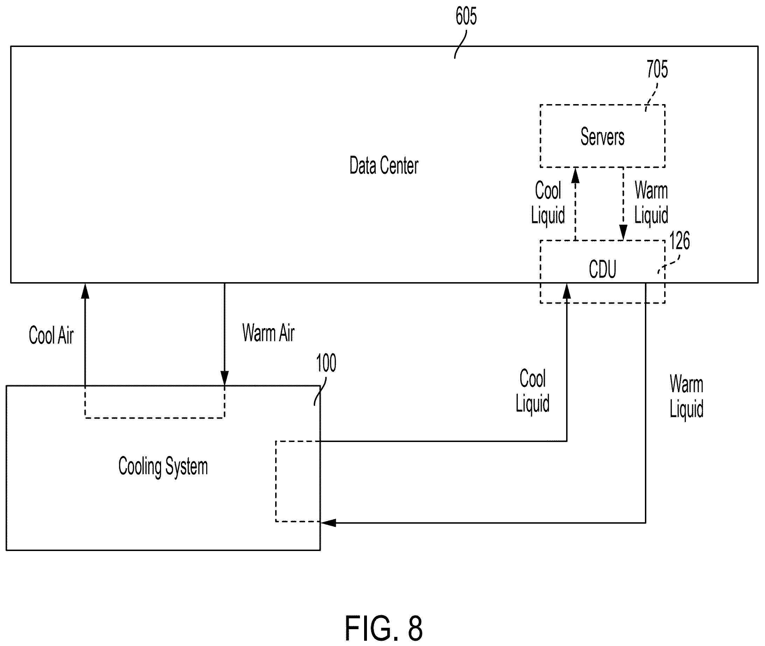

FIGS. 7-8 illustrate how another coolant distribution unit 126 can be utilized with various embodiments of cooling system 100, with the coolant distribution unit 126 being partially located within the facility in each of FIG. 7 and FIG. 8. In FIG. 8, coolant distribution unit 126 is coupled to servers 705 and is configured cool liquid thereto and receive cool liquid therefrom.

While example embodiments have been described with reference to the figures, it will be understood by those of ordinary skill in the art that various changes in form and details may be made therein without departing from the scope as defined by the following claims.
The disclosure comprises the following items:
1. A cooling system for a data center, the cooling system comprising:
   an air-to-air heat exchanger;
   a first water coil located beneath the air-to-air heat exchanger;
   a first fan unit configured to draw air through the first water coil and the air-to-air heat exchanger in a first direction, wherein the first fan unit is further configured to exhaust air to a location external to the data center; and
   a second fan unit configured to blow air from the data center, in a second direction normal to the first direction, through the air-to-air heat exchanger.
2. The cooling system of item 1, further comprising:
   a condensing coil coupled between the air-to-air heat exchanger and the first fan unit, wherein the first fan unit is configured to draw air through the condensing coil, and wherein the condensing coil is further configured to transfer heat from refrigerant to surrounding air;
   a second water coil coupled to the air-to-air heat exchanger on a side opposite of the second fan unit, wherein the second fan unit is further configured to blow air through the second water coil, wherein the second water coil is configured to receive cooling fluid; and
   a coolant distribution unit configured to provide cooling fluid to the first water coil.
3. The cooling system of item 1 or item 2, wherein the cooling fluid is water, and wherein the cooling system further comprises:
   a plate heat exchanger coupled to receive, via warm water piping, warm water from the coolant distribution unit and further coupled to provide cold water, via cold water piping, to the coolant distribution unit; and
   a compressor configured to, using heat drawn from the plate heat exchanger, compress refrigerant provided to the condensing coil; and
   wherein the plate heat exchanger is further coupled to receive the refrigerant from the condensing coil.
4. The cooling system of any preceding item, further comprising first and second three-way valves in cold water piping and a third three-way valve in the warm water piping, wherein, when operating in a summer hybrid-cooling mode:
   the first three-way valve is configured to direct cold water from the plate heat exchanger and the first water coil to the second three-way valve;
   the second three-way valve is configured to direct cold water to the second water coil and the coolant distribution unit; and
   the third three-way valve is configured to direct warm water from the second water coil to the first water coil and the plate heat exchanger.
5. The cooling system of any preceding item further comprising first and second three-way valves in cold water piping and a third three-way valve in the warm water piping, wherein, when operating in a summer air-cooling mode:
   the first three-way valve is configured to direct cold water from the plate heat exchanger to the second three-way valve and is further configured to inhibit cold water flow from the first water coil;
   the second three-way valve is configured to direct cold water to the second water coil and inhibit cold water flow to the coolant distribution unit; and
   the third three-way valve is configured to direct warm water from the second water coil exclusively to the plate heat exchanger, wherein a check valve is configured to inhibit warm water from being provided to the coolant distribution unit.
6. The cooling system of any preceding item, further comprising first and second three-way valves in cold water piping and a third three-way valve in the warm water piping, wherein, when operating in a winter hybrid-cooling mode:
   the first three-way valve is configured to direct cold water from the first water coil to the second three-way valve, and further configured to inhibit cold water from being provided to the second three-way valve from the plate heat exchanger;
   the second three-way valve is configured to direct cold water from the first three-way valve to the coolant distribution unit and the second water coil; and
   the third three-way valve is configured to direct warm water from the second water coil and the coolant distribution unit to the first water coil, and further configured to inhibit warm water from being provided to the plate heat exchanger.
7. The cooling system of any preceding item, further comprising first and second three-way valves in cold water piping and a third three-way valve in the warm water piping, wherein, when operating in a winter air-cooling mode, the first, second, and third three-way valves are configured to inhibit flow of cold water and warm water between the coolant distribution unit, the first water coil, the second water coil, and the plate heat exchanger.
8. The cooling system of any preceding item, further comprising a two-way valve configured to inhibit flow of refrigerant from the condensing coil and to the plate heat exchanger during operation in the winter air-cooling mode.
9. The cooling system of any preceding item, wherein the first water coil comprises a stainless steel water coil.
10. A method for operating a cooling system for cooling a facility, the method comprising:
   blowing air in a first direction, using a first fan unit, through an air-to-air heat exchanger and a first water coil located beneath the air-to-air heat exchanger;
   receiving cooling water, at the first water coil, from a coolant distribution unit;
   blowing air, using a second fan unit, through the air-to-air heat exchanger in a second direction normal to the first direction, and through a second water coil, wherein the second water coil and the second fan unit are located on opposite sides of the air-to-air heat exchanger; and
   exhausting air to a location external to the facility, using the first fan unit.
11. The method of item 10, wherein exhausting air to the location external to the facility is performed by the first fan unit, and wherein the method further comprises the second fan unit blowing air through the air-to-air heat exchanger in a direction normal to the first direction.
12. The method of item 10 or item 11, further comprising:
   drawing air, using the first fan unit, through a condensing coil coupled between the air to air heat exchanger and the first fan unit, the condensing coil transferring heat from refrigerant to surrounding air;
   receiving cooling fluid at a second water coil located on a side of the air to air heat exchanger opposite the second fan unit; and
   blowing air, using the second fan unit, through a second water coil.
13. The method of any of items 10-12, wherein the cooling fluid is water, and wherein the method further comprises:
   providing warm water, via warm water piping, from the coolant distribution unit to a plate heat exchanger and receiving cold water, via cold water piping, from the plate heat exchanger back to the coolant distribution unit; and
   compressing refrigerant, using a compressor, with heat drawn from the plate heat exchanger and providing the refrigerant to the condensing coil, and thereafter providing the refrigerant from the condensing coil to the plate heat exchanger.
14. The method of any of items 10-13, further comprising operating in a summer hybrid cooling mode, wherein operating in the summer hybrid cooling mode comprises:
   directing, using a first three way valve, cold water from the plate heat exchanger and the first water coil to a second three way valve;
   directing, using the second three way valve, cold water to the second water coil and to the coolant distribution unit; and
   directing, using a third three way valve, warm water from the second water coil to the first water coil and the plate heat exchanger.
15. The method of any of items 10-14, further comprising operating in a summer air-cooling mode, wherein operating in the summer air-cooling mode comprises:
   configuring a first three way valve to direct cold water from the plate heat exchanger to a second three way valve while inhibiting cold water flow from the first water coil;
   configuring the second three way valve to direct cold water to the second water coil while inhibiting cold water flow to the coolant distribution unit; and
   configuring a third three way valve to direct warm water from the second water coil exclusively to the plate heat exchanger, with a check valve inhibiting warm water from being provided to the coolant distribution unit.
16. The method of any of items 10-15, further comprising operating in a winter hybrid cooling mode, wherein operating in the winter hybrid cooling mode comprises:
   configuring a first three way valve to direct cold water from the first water coil to a second three way valve and to inhibit provision of cold water from the plate heat exchanger;
   configuring the second three way valve to direct cold water to the coolant distribution unit and to the second water coil; and
   configuring a third three way valve to direct warm water from the second water coil and the coolant distribution unit to the first water coil while inhibiting provision of warm water to the plate heat exchanger.
17. The method of any of items 10-16, further comprising operating in a winter air cooling mode, wherein operating in the winter air cooling mode comprises:
   inhibiting, using first, second, and third three way valves, flow of cold water and warm water between the coolant distribution unit, the first water coil, the second water coil, and a plate heat exchanger.
18. The method of any of items 10-17, further comprising:
   inhibiting flow of refrigerant from a condensing coil to the plate heat exchanger during operation in the winter air cooling mode, wherein the inhibiting comprises closing a two-way valve.
19. A cooling system for a data center, the cooling system comprising:
   an air-to-air heat exchanger having a plurality of plates;
   a first water coil located beneath the air-to-air heat exchanger and comprising a stainless-steel water coil;
   a first fan unit positioned to draw external ambient air sequentially through the first water coil and the air-to-air heat exchanger in a first direction and to exhaust air external to the data center;
   a second fan unit positioned to blow facility air through the air-to-air heat exchanger in a second direction normal to the first direction;
   a condensing coil coupled between the air-to-air heat exchanger and the first fan unit; and
   a set of sprayers located between the condensing coil and the air-to-air heat exchanger and configured to wet plates of the air-to-air heat exchanger.
20. The cooling system of item 19, wherein the condensing coil is configured to transfer heat from refrigerant to surrounding air, wherein the first fan unit is arranged to draw air through the condensing coil, and wherein the system further comprises:
   a second water coil coupled to an air-to-air heat exchanger on a side opposite of the second fan unit, wherein the second fan unit is further configured to blow air through the second water coil, wherein the second water coil is configured to receive cooling fluid;
   a plate heat exchanger coupled to receive, via warm water piping, warm water from a coolant distribution unit and further coupled to provide cold water, via cold water piping, to the coolant distribution unit; and
   a compressor configured to, using heat drawn from the plate heat exchanger, compress refrigerant provided to the condensing coil; and
   wherein the plate heat exchanger is further coupled to receive the refrigerant from the condensing coil.

## Claims

1. A cooling system for a data center, the cooling system comprising:
an air-to-air heat exchanger;
a first water coil located beneath the air-to-air heat exchanger;
a first fan unit configured to draw air through the first water coil and the air-to-air heat exchanger in a first direction, wherein the first fan unit is further configured to exhaust air to a location external to the data center; and
a second fan unit configured to blow air from the data center, in a second direction normal to the first direction, through the air-to-air heat exchanger.

2. The cooling system of claim 1, further comprising:
a condensing coil coupled between the air-to-air heat exchanger and the first fan unit, wherein the first fan unit is configured to draw air through the condensing coil, and wherein the condensing coil is further configured to transfer heat from refrigerant to surrounding air;
a second water coil coupled to the air-to-air heat exchanger on a side opposite of the second fan unit, wherein the second fan unit is further configured to blow air through the second water coil, wherein the second water coil is configured to receive cooling fluid; and
a coolant distribution unit configured to provide cooling fluid to the first water coil.

3. The cooling system of claim 2, wherein the cooling fluid is water, and wherein the cooling system further comprises:
a plate heat exchanger coupled to receive, via warm water piping, warm water from the coolant distribution unit and further coupled to provide cold water, via cold water piping, to the coolant distribution unit; and
a compressor configured to, using heat drawn from the plate heat exchanger, compress refrigerant provided to the condensing coil; and
wherein the plate heat exchanger is further coupled to receive the refrigerant from the condensing coil.

4. The cooling system of claim 3, further comprising first and second three-way valves in the cold water piping and a third three-way valve in the warm water piping, wherein, when operating in a summer hybrid-cooling mode:
the first three-way valve is configured to direct cold water from the plate heat exchanger and the first water coil to the second three-way valve;
the second three-way valve is configured to direct cold water to the second water coil and the coolant distribution unit; and
the third three-way valve is configured to direct warm water from the second water coil to the first water coil and the plate heat exchanger.

5. The cooling system of claim 3 further comprising first and second three-way valves in the cold water piping and a third three-way valve in the warm water piping, wherein, when operating in a summer air-cooling mode:
the first three-way valve is configured to direct cold water from the plate heat exchanger to the second three-way valve and is further configured to inhibit cold water flow from the first water coil;
the second three-way valve is configured to direct cold water to the second water coil and inhibit cold water flow to the coolant distribution unit; and
the third three-way valve is configured to direct warm water from the second water coil exclusively to the plate heat exchanger, wherein a check valve is configured to inhibit warm water from being provided to the coolant distribution unit.

6. The cooling system of claim 3, further comprising first and second three-way valves in the cold water piping and a third three-way valve in the warm water piping, wherein, when operating in a winter hybrid-cooling mode:
the first three-way valve is configured to direct cold water from the first water coil to the second three-way valve, and further configured to inhibit cold water from being provided to the second three-way valve from the plate heat exchanger;
the second three-way valve is configured to direct cold water from the first three-way valve to the coolant distribution unit and the second water coil; and
the third three-way valve is configured to direct warm water from the second water coil and the coolant distribution unit to the first water coil, and further configured to inhibit warm water from being provided to the plate heat exchanger.

7. The cooling system of claim 3, further comprising first and second three-way valves in the cold water piping and a third three-way valve in the warm water piping, wherein, when operating in a winter air-cooling mode, the first, second, and third three-way valves are configured to inhibit flow of cold water and warm water between the coolant distribution unit, the first water coil, the second water coil, and the plate heat exchanger, and optionally: the cooling system further comprising a two-way valve configured to inhibit flow of refrigerant from the condensing coil and to the plate heat exchanger during operation in the winter air-cooling mode.

8. The cooling system of any preceding claim, wherein the first water coil comprises a stainless steel water coil.

9. A method for operating a cooling system for cooling a facility, the method comprising:
blowing air in a first direction, using a first fan unit, through an air-to-air heat exchanger and a first water coil located beneath the air-to-air heat exchanger;
receiving cooling water, at the first water coil, from a coolant distribution unit;
blowing air, using a second fan unit, through the air-to-air heat exchanger in a second direction normal to the first direction, and through a second water coil, wherein the second water coil and the second fan unit are located on opposite sides of the air-to-air heat exchanger; and
exhausting air to a location external to the facility, using the first fan unit.

10. The method of claim 9, wherein exhausting air to the location external to the facility is performed by the first fan unit, and wherein the method further comprises the second fan unit blowing air through the air-to-air heat exchanger in a direction normal to the first direction.

11. The method of claim 9 or claim 10, further comprising:
drawing air, using the first fan unit, through a condensing coil coupled between the air to air heat exchanger and the first fan unit, the condensing coil transferring heat from refrigerant to surrounding air;
receiving cooling fluid at a second water coil located on a side of the air to air heat exchanger opposite the second fan unit; and
blowing air, using the second fan unit, through a second water coil.

12. The method of claim 11, wherein the cooling fluid is water, and wherein the method further comprises:
providing warm water, via warm water piping, from the coolant distribution unit to a plate heat exchanger and receiving cold water, via cold water piping, from the plate heat exchanger back to the coolant distribution unit; and
compressing refrigerant, using a compressor, with heat drawn from the plate heat exchanger and providing the refrigerant to the condensing coil, and thereafter providing the refrigerant from the condensing coil to the plate heat exchanger.

13. The method of claim 12, further comprising:
operating in a summer hybrid cooling mode, wherein operating in the summer hybrid cooling mode comprises:
directing, using a first three way valve, cold water from the plate heat exchanger and the first water coil to a second three way valve;
directing, using the second three way valve, cold water to the second water coil and to the coolant distribution unit; and
directing, using a third three way valve, warm water from the second water coil to the first water coil and the plate heat exchanger; or
operating in a summer air-cooling mode, wherein operating in the summer air-cooling mode comprises:
configuring a first three way valve to direct cold water from the plate heat exchanger to a second three way valve while inhibiting cold water flow from the first water coil;
configuring the second three way valve to direct cold water to the second water coil while inhibiting cold water flow to the coolant distribution unit; and
configuring a third three way valve to direct warm water from the second water coil exclusively to the plate heat exchanger, with a check valve inhibiting warm water from being provided to the coolant distribution unit; or
operating in a winter hybrid cooling mode, wherein operating in the winter hybrid cooling mode comprises:
configuring a first three way valve to direct cold water from the first water coil to a second three way valve and to inhibit provision of cold water from the plate heat exchanger;
configuring the second three way valve to direct cold water to the coolant distribution unit and to the second water coil; and
configuring a third three way valve to direct warm water from the second water coil and the coolant distribution unit to the first water coil while inhibiting provision of warm water to the plate heat exchanger.

14. The method of any of claims 10-12, further comprising operating in a winter air cooling mode, wherein operating in the winter air cooling mode comprises:
inhibiting, using first, second, and third three way valves, flow of cold water and warm water between the coolant distribution unit, the first water coil, the second water coil, and a plate heat exchanger.

15. The method of claim 14, further comprising:
inhibiting flow of refrigerant from a condensing coil to the plate heat exchanger during operation in the winter air cooling mode, wherein the inhibiting comprises closing a two-way valve.
